# EUROPEAN PATENT APPLICATION

(11) **EP 4 027 381 A1**
(43) Date of publication of application: **13.07.2022**
(21) Application number: 20859935.7
(22) Date of filing: 16.06.2020
(51) Int. Cl.: H01L 23/473, H01S 5/022

(54) **SEMICONDUCTOR LASER DEVICE**

(30) Priority: 06.09.2019 JP 2019163311
(71) Applicant: Panasonic Intellectual Property Management Co., Ltd., Osaka-shi, Osaka 540-6207 (JP)
(72) Inventor: OOMORI Kouji, Osaka-shi, Osaka 540-6207 (JP)
(74) Representative: Vigand, Philippe
(86) International application number: PCT/JP2020/023538
(87) International publication number: WO 2021/044698

(57) **Abstract**

A semiconductor laser device includes a multilayer substrate, a first conductive layer (submount) that is disposed on the multilayer substrate, a semiconductor laser element located in a first region of the first conductive layer, a first bump located on a surface of the semiconductor laser element, the surface not facing the first conductive layer, a first electrode electrically connected to the first bump, a second conductive layer located in a second region of the first conductive layer, and a second electrode electrically connected to the first conductive layer via the second conductive layer.

## Description

### TECHNICAL FIELD

The present disclosure relates to a semiconductor laser device.

### BACKGROUND ART

In a semiconductor laser device, a laser diode (LD) chip is usually fixed by being sandwiched between an anode side electrode block and a cathode side electrode block.

In the semiconductor laser device, because a large current flows through the LD chip, the higher the output, the larger the calorific value. For this reason, thermal stress is likely to be generated between the LD chip and the electrode blocks or between the LD chip and another connection component. When the thermal stress is generated, the electrical connection between the components decreases (that is, the electric resistance increases), which tends to decrease the laser output or decrease the reliability of the semiconductor laser device.

In PTL 1, a semiconductor laser element is disposed on a submount, connection between the semiconductor laser element and the submount and connection between the submount and a first electrode block located below the submount are performed by soldering, and connection between the semiconductor laser element and a second electrode block located above the semiconductor laser element is performed via a bump. At this time, providing a metal layer and a metal sheet between the bump and the second electrode block can alleviate thermal stress due to a difference in thermal expansion coefficient between the semiconductor laser element and the second electrode block and can stably secure electrical connection between the semiconductor laser element and the second electrode block.

### Citation List

### Patent Literature

PTL 1:JP domestic re-publication of PCT publication No. 2016-103536

### SUMMARY OF THE INVENTION

### Technical problem

A semiconductor laser device having high reliability against heat is achieved. Solution to problem

In view of the above, one aspect of the present disclosure relates to a semiconductor laser device including a multilayer substrate, a first conductive layer that is an uppermost layer of the multilayer substrate or is disposed on the multilayer substrate, a semiconductor laser element located in a first region of the first conductive layer, a first bump located on a surface of the semiconductor laser element, the surface not facing the first conductive layer, a first electrode electrically connected to the first bump, a second conductive layer located in a second region of the first conductive layer, and a second electrode electrically connected to the first conductive layer via the second conductive layer.

### Advantageous effects of invention

According to the present disclosure, it is possible to achieve a semiconductor laser device having high reliability against heat.

### BRIEF DESCRIPTION OF THE DRAWINGS

Fig. 1 is a cross-sectional view showing a schematic configuration of a semiconductor laser device according to one exemplary embodiment of the present disclosure.
Fig. 2 is an enlarged cross-sectional view of a main part of the semiconductor laser device in Fig. 1.
Fig. 3 is an enlarged cross-sectional view showing a schematic configuration of a main part of a semiconductor laser device according to another exemplary embodiment of the present disclosure.

### DESCRIPTION OF EMBODIMENTS

A semiconductor laser device according to the present exemplary embodiment includes a multilayer substrate, a first conductive layer that is an uppermost layer of the multilayer substrate or is disposed on the multilayer substrate, and a semiconductor laser element. The semiconductor laser element is held by the first conductive layer and the multilayer substrate. As the semiconductor laser element, for example, a semiconductor laser element having a first main surface and a second main surface which is a back surface of the first main surface and having a terminal on each of the first main surface and the second main surface is used. In this case, the semiconductor laser element may be held such that, for example, the second main surface faces the first conductive layer. At this time, the first conductive layer may be electrically connected to the terminal formed on the second main surface.

The semiconductor laser element is located in a first region of the first conductive layer. A second region of the first conductive layer is provided with a second conductive layer.

The semiconductor laser device includes a first bump on the surface (first main surface) of the semiconductor laser element, the surface not facing the first conductive layer. The semiconductor laser device further includes a first electrode electrically connected to the first bump, and a second electrode electrically connected to the first conductive layer via the second conductive layer. As a result, the terminal formed on the first main surface and the first electrode is electrically connected via the first bump. The terminal formed on the second main surface and the second electrode are electrically connected via the first conductive layer and the second conductive layer. This allows the thermal stress generated between the semiconductor laser element and the first electrode and the thermal stress generated between the first conductive layer and the second electrode to be alleviated by the first bump and the second conductive layer, respectively, and a semiconductor laser device having high reliability against heat can be achieved. In addition, when the first conductive layer contains an element common to the second electrode, the thermal stress generated between the first conductive layer and the second electrode decreases, and it is easy to alleviate the thermal stress.

Furthermore, in the semiconductor laser device according to the present exemplary embodiment, both the first electrode and the second electrode can be arranged on the same side with respect to the semiconductor laser element. Therefore, it is also easy to dispose a cooling mechanism in the vicinity of the multilayer substrate, that is, at a position close to the semiconductor laser element, and directly cool the semiconductor laser element. The cooling mechanism may be disposed in the multilayer substrate. In addition, as compared with a case where the semiconductor laser element is disposed between the first electrode and the second electrode, the layout of the cooling mechanism can be freely determined without being limited by the second electrode, and therefore it is easy to increase the size of the cooling mechanism. As a result, the cooling efficiency is enhanced, and therefore the performance degradation due to the heat of the semiconductor laser device is suppressed, and the reliability is enhanced.

The second electrode is electrically connected to the first conductive layer. However, when the second electrode and the first conductive layer are brought into direct contact with each other, contact resistance between the second electrode and the first conductive layer is large. In addition, the first conductive layer is likely to warp due to heat, and the electrical connection between the second electrode and the first conductive layer is likely to decrease. Therefore, in the present exemplary embodiment, the second conductive layer is provided between the second electrode and the first conductive layer.

The second conductive layer has a role of alleviating the thermal stress caused by the first conductive layer and the second electrode and reducing contact resistance between the first conductive layer and the second electrode. The second conductive layer may include a metal film having a lower hardness than the first conductive layer. Alternatively, the second conductive layer may include a second bump, and the second electrode and the first conductive layer may be electrically connected via the second bump. Here, the hardness of the first conductive layer and the second conductive layer means Vickers hardness.

Hereinafter, specific aspects of the semiconductor laser device according to the present exemplary embodiment will be described in more detail with reference to the drawings.

### <First exemplary embodiment

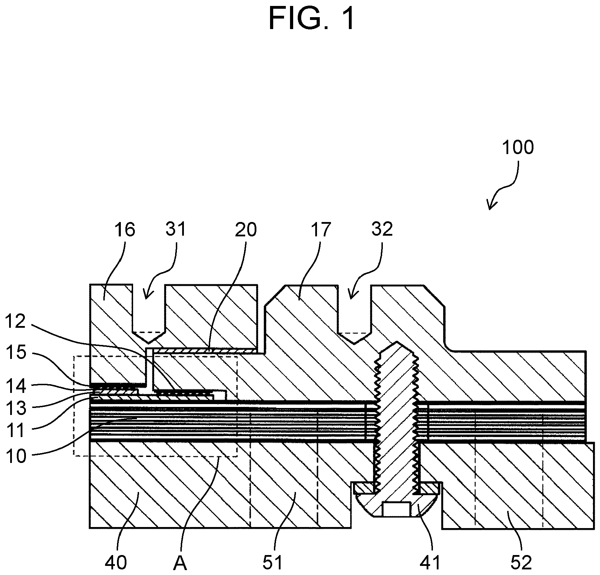

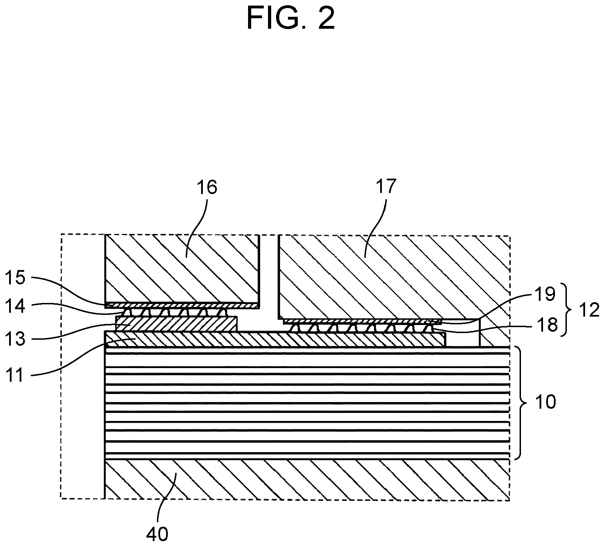

Fig. 1 is a cross-sectional view showing a schematic configuration of semiconductor laser device 100 according to one exemplary embodiment of the present disclosure. Fig. 2 is an enlarged cross-sectional view of area A in Fig. 1. Semiconductor laser device 100 includes multilayer substrate 10, submount 11, conductive layer 12, semiconductor laser element 13, first bump 14, first electrode 16, and second electrode 17.

Semiconductor laser element 13 is, for example, an edge emitting laser (EEL) type laser diode (LD) chip. In the edge emitting laser type LD chip, terminals for supplying a current to an upper surface (first main surface) and a lower surface (second main surface) of the chip are formed. Supplying a current to the laser diode via both terminals causes laser light to be emitted from an end surface between the upper surface and the lower surface of the chip. The LD chip may have a plurality of light emitting points from which laser light is emitted.

Semiconductor laser element 13 is held on submount 11 provided on multilayer substrate 10. Submount 11 has conductivity and corresponds to the first conductive layer.

As submount 11 which is the first conductive layer, a submount having a linear expansion coefficient equivalent to that of semiconductor laser element 13 can be preferably used. Submount 11 contains, for example, a copper-tungsten alloy (CuW) as a main component from the viewpoint of thermal expansion coefficient. Submount 11 may contain a copper-molybdenum alloy (CuMo) as a main component. Submount 11 may be electrically connected to the terminal formed on the lower surface (second main surface) of semiconductor laser element 13 by, for example, solder containing gold (Au) and tin (Sn). The thickness of submount 11 may be, for example, 5 ₁₁m to 10 µm .

Multilayer substrate 10 is, for example, a laminate of a copper plate and an aluminum nitride plate, and is provided with a space for allowing cooling water to flow therein. This allows semiconductor laser element 13 to be directly cooled without mediating first electrode 16 and second electrode 17. A multilayer substrate formed of such a laminate and having a cooling water path disposed therein is also called a microchannel cooler (MCC).

The uppermost layer of multilayer substrate 10 as a laminate is, for example, a copper plate and has conductivity. The uppermost copper plate and submount 11 may be electrically connected by, for example, solder containing silver (Ag) and tin (Sn).

First bump 14 is provided on the upper surface (first main surface) of semiconductor laser element 13, and electrically connects the terminal formed on the upper surface (first main surface) of semiconductor laser element 13 and first electrode 16. First bump 14 is, for example, a loop-shaped bump electrode, and contains, for example, gold (Au) as a main component. Even when there is a difference in thermal expansion coefficient between semiconductor laser element 13 and first electrode 16, first bump 14 can move while maintaining electrical connection between the upper surface of semiconductor laser element 13 and first electrode 16 and can alleviate the thermal stress.

Metal film 15 may be provided between first bump 14 and first electrode 16. Metal film 15 contains, for example, gold (Au) as a main component. Metal film 15 may be formed by stacking one or a plurality of gold foils to have a predetermined thickness. The tip of first bump 14 bites into and is in physical contact with metal film 15. This allows the electrical connection between the upper surface of semiconductor laser element 13 and first electrode 16 to increase while the thermal stress is alleviated. The thickness of metal film 15 may be, for example, 10 ₁₁m to 30 ₁₁m.

In submount 11, conductive layer 12 is provided in a region where semiconductor laser element 13 is not disposed. Conductive layer 12 corresponds to the second conductive layer. Conductive layer 12 is electrically connected to second electrode 17. As a result, submount 11 (first conductive layer) and second electrode 17 are electrically connected via conductive layer 12 (second conductive layer). Conductive layer 12 includes, for example, second bump 18.

Second bump 18 is, for example, a loop-shaped bump electrode similar to first bump 14, and contains, for example, gold (Au) as a main component. In some cases, submount 11 warps due to thermal expansion, or a difference in thermal expansion coefficient occurs between submount 11 and second electrode 17. Even in such a case, second bump 18 can move between submount 11 and second electrode 17 while maintaining good electrical connection and can alleviate the thermal stress.

Conductive layer 12 may include metal film 19 interposed between second bump 18 and second electrode 17. Metal film 19 contains, for example, gold (Au) as a main component. Metal film 19 may be formed by stacking one or a plurality of gold foils to have a predetermined thickness. In this case, the tip of second bump 18 may bite into and come into physical contact with metal film 19. This allows the electrical connection between submount 11 and second electrode 17 to increase while the thermal stress is alleviated. The thickness of metal film 19 may be, for example, 10 µm to 30 µm.

First electrode 16 and second electrode 17 contain, for example, copper (Cu) as a main component. First electrode 16 and second electrode 17 may be formed by plating a copper material with nickel (Ni), gold (Au), or the like, for example. First electrode 16 and second electrode 17 are disposed on the same side as semiconductor laser element 13 but are insulated from each other by insulating layer 20. Insulating layer 20 may be, for example, a polyimide film. In addition, first electrode 16 and second electrode 17 are respectively provided with bolt-holes 31, 32 for connecting to an external power supply.

For example, second electrode 17 may be fixed above multilayer substrate 10 by disposing multilayer substrate 10 on base 40 and screwing second electrode 17 and multilayer substrate 10 from base 40 using screw 41 in a state where multilayer substrate 10 is sandwiched between second electrode 17 and base 40. Base 40 is provided with Inlet hole 51, Outlet hole 52 through holes 51, 52 for supplying cooling water.

According to the configuration of semiconductor laser device 100 described above, performance degradation due to heat is suppressed, and reliability of the semiconductor laser device against heat can be enhanced.

### <Second exemplary embodiment

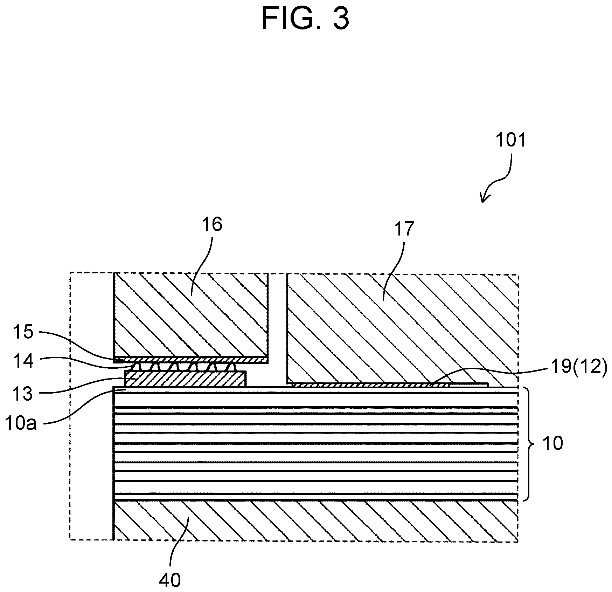

Fig. 3 is a cross-sectional view showing a schematic configuration of semiconductor laser device 101 according to one exemplary embodiment of the present disclosure. Fig. 3 is an enlarged cross-sectional view in which a main part of the semiconductor laser device is enlarged, similarly to Fig. 2.

Semiconductor laser device 101 shown in Fig. 3 has a configuration in which the semiconductor laser element is directly disposed on multilayer substrate 10 without providing submount 11 in semiconductor laser device 100 shown in Fig. 1 and Fig. 2. In this case, copper plate 10a, which is the uppermost layer of multilayer substrate 10, corresponds to the first conductive layer described above. In this case, the thickness of copper plate 10a as the first conductive layer may be, for example, 50 µm to 200 µm.

Copper plate 10a as the first conductive layer and the terminal formed on the lower surface (second main surface) of semiconductor laser element 13 may be electrically connected by, for example, solder mainly made of tin (Sn) or gold (Au).

Copper plate 10a as the first conductive layer is electrically connected to second electrode 17 via conductive layer 12 as the second conductive layer. Conductive layer 12 includes metal film 19. When second electrode 17 is made of a copper material, the thermal stress applied between copper plate 10a as the first conductive layer and second electrode 17 can be reduced. However, usually, the surface of metal has minute irregularities when viewed microscopically even though the surface is flat when viewed macroscopically. Therefore, when second electrode 17 and the first conductive layer are brought into direct contact with each other, the contact area at the interface between second electrode 17 and the first conductive layer is small, and the contact resistance tends to increase. As a result, it is difficult to maintain good electrical connection between second electrode 17 and the first conductive layer.

However, by interposing metal film 19 between second electrode 17 and the first conductive layer, minute recesses of the first conductive layer are filled with metal film 19, and the contact area at the interface can be increased. This allows the contact resistance to be maintained low. Therefore, the electrical connection between second electrode 17 and the first conductive layer can be increased, and a highly reliable semiconductor laser device can be achieved.

From the viewpoint of reducing the contact resistance, metal film 19 as the second conductive layer is preferably a material having a lower hardness (softer) than the first conductive layer such that metal film 19 can fill minute recesses of the first conductive layer by pressurization. Metal film 19 may be, for example, a film containing gold (Au) as a main component.

Other configurations of semiconductor laser device 101 are similar to those of semiconductor laser device 100, and description thereof is omitted. In semiconductor laser device 101 as well, similarly to semiconductor laser device 100, second electrode 17 and the first conductive layer may be electrically connected via second bump 18.

The above-described exemplary embodiments are merely examples of the present disclosure, and the specific configuration of each unit is not limited to the above-described specific examples. It is needless to say that the configuration can be appropriately modified and designed within a range in which the operation and effect of the present disclosure are exhibited.

### INDUSTRIAL APPLICABILITY

The semiconductor laser device of the present disclosure can be used for laser processing because high output is obtained.

### REFERENCE MARKS IN THE DRAWINGS

100, 101: semiconductor laser device
10: multilayer substrate
10a: copper plate
11: submount
12: conductive layer (second conductive layer)
18: second bump
19: metal film
13: semiconductor laser element
14: first bump
15: metal film
16: first electrode
17: second electrode
20: insulating layer
31, 32: Bolt holes
40: base
51: Inlet hole
52: Outlet hole

## Claims

1. A semiconductor laser device comprising:
a multilayer substrate;
a first conductive layer that is an uppermost layer of the multilayer substrate or is disposed on the multilayer substrate;
a semiconductor laser element located in a first region of the first conductive layer;
a first bump located on a surface of the semiconductor laser element, the surface not facing the first conductive layer;
a first electrode electrically connected to the first bump;
a second conductive layer located in a second region of the first conductive layer; and
a second electrode electrically connected to the first conductive layer via the second conductive layer.

2. The semiconductor laser device according to Claim 1, wherein the first conductive layer contains an element common to the second electrode.

3. The semiconductor laser device according to Claim 1 or 2, wherein the second conductive layer includes a metal film having a hardness lower than a hardness of the first conductive layer.

4. The semiconductor laser device according to any one of Claims 1 to 3, wherein the second conductive layer includes a second bump.

5. The semiconductor laser device according to any one of Claims 1 to 4, wherein the multilayer substrate is provided with a path for cooling water inside.
